# EUROPÄISCHE PATENTSCHRIFT

(11) **EP 2 290 120 B1**
(45) Veröffentlichungstag und Bekanntmachung des Hinweises auf die Patenterteilung: **28.10.2015**
(21) Anmeldenummer: 10015785.8
(22) Anmeldetag: 21.07.2008
(51) Int. Cl.: C23C 14/24, C23C 14/26, C23C 14/30, C30B 23/06

(54) **HOCHTEMPERATUR-VERDAMPFERZELLE MIT KONISCHEM HEIZELEMENT**
HIGH TEMPERATURE EVAPORATOR CELL HAVING CONICAL HEATING ELEMENT
CELLULE D'ÉVAPORATION À HAUTE TEMPÉRATURE AVEC UN ÉLÉMENT CHAUFFANTE CONIQUE

(30) Priorität: 27.07.2007 DE 102007035166
(43) Veröffentlichungstag der Anmeldung: 02.03.2011
(62) Teilanmeldung aus: 08784919.6
(73) Patentinhaber: CreaTec Fischer & Co. GmbH, 74391 Erligheim (DE); Forschungsverbund Berlin e.V., 12489 Berlin-Adlershof (DE)
(72) Erfinder: Braun, Wolfgang, 13349 Berlin (DE); Fischer, Albrecht, 74369 Löchgau (DE); Watahiki, Tatsuro, Tokyo 145-0065 (JP)
(74) Vertreter: Hertz, Oliver

(56) Entgegenhaltungen:
- EP-A1- 0 122 088
- EP-A2- 1 732 129
- WO-A1-2006/043723
- US-A- 3 281 517
- US-A- 5 016 566
- US-A- 5 034 604
- US-A- 5 944 903
- US-A1- 2007 204 798
- AZAROUAL E M ET AL: "REALIZATION AND CHARACTERIZATION OF A BEAM OF TITANIUM ATOMS", JOURNAL DE PHYSIQUE III, EDITIONS DE PHYSIQUE, PARIS, FR, Bd. 2, Nr. 6, 1. Juni 1992 (1992-06-01), Seiten 899-904, XP000305578, ISSN: 1155-4320, DOI: 10.1051/JP3:1992167

## Beschreibung

Die Erfindung betrifft eine Verdampferzelle mit den Merkmalen des Oberbegriffs von Anspruch 1, insbesondere eine Effusions-Verdampferzelle zur Überführung eines Verdampfungsguts in die Gasphase (Verdampfung, Sublimation). Es wird auch ein Verfahren zur Verdampfung von Verdampfungsgut mit einer derartigen Verdampferzelle beschrieben.

Die Verdampfung von Materialien zur Abscheidung dünner Schichten ist ein verbreitetes Verfahren, z. B. in der technischen Physik und in der Halbleitertechnik. Bei der Verwendung von hochschmelzenden Materialien, die erst bei extrem hohen Temperaturen (oberhalb von z. B. 1800°C, insbesondere oberhalb von 2000°C) in die Gasphase übergehen, gibt es besondere Anforderungen insbesondere an die Temperaturstabilität und die Einstellung der Verdampfungsrate bei der Verdampfung. Des Weiteren besteht z. B. bei der Herstellung von Dünnschicht-Bauelementen für die CMOS-Technik ein Interesse an einer gut steuerbaren und reproduzierbaren, nichtreaktiven Dampfabscheidung von Isolatorschichten, bei der das Verdampfungsgut die gewünschte stöchiometrische Zusammensetzung der Isolatorschichten aufweist.

In DE 10 2005 025 935 A1 wird eine Verdampferzelle beschrieben, die einen Tiegel zur Aufnahme von Verdampfungsgut und einen Heizwiderstand umfasst, der sowohl für eine Widerstandsheizung und als auch für eine Elektronenstrahlheizung des Tiegels angeordnet ist. Der Heizwiderstand umfasst eine Heizwendel, die den Tiegel allseitig umgibt, mit Heizelementen, die sich entlang der axialen Ausrichtung des Tiegels erstrecken. Die Heizwendel ist mit elektrischen Isolatoren an einer Abschirmung befestigt, die den Tiegel umgibt. Zur Vermeidung unerwünschter Magnetfelder bei der Beaufschlagung des Heizwiderstands mit einem Betriebsstrom sind die Heizelemente paarweise entgegengesetzt ausgerichtet und in Reihe geschaltet. Für die Steuerung der Widerstandsheizung und der Elektronenstrahlheizung sind Regelkreise vorgesehen, die mit einem Temperatursensor verbunden sind.

Mit der Verdampferzelle gemäß DE 10 2005 025 935 A1 wird ein stufenloser Übergang von der Widerstandsheizung zur Elektronenstrahlheizung ermöglicht, so dass die Temperatur des Verdampfungsguts in einem großen Temperaturbereich eingestellt werden kann. Beispielsweise ist in einem niedrigeren Temperaturbereich eine Reinigung des Materials und in einem höheren Temperaturbereich die Überführung des Materials in die Gasphase vorgesehen.

Mit der herkömmlichen Verdampferzelle können die folgenden Probleme auftreten. Die elektrischen Isolatoren zur Befestigung der Heizwendel können durch den Betrieb bei hohen Temperaturen beschädigt werden. Bei Funktionsverlust eines Isolators kann ein Kurzschluss auftreten, durch den die gesamte Verdampferzelle ausfällt. Des Weiteren können Variationen des elektrischen Widerstands entlang der Länge der Heizwendel auftreten. Die Variationen können eine ungleichförmige Erwärmung des Verdampfungsguts im Tiegel ergeben. Die genannten Probleme treten insbesondere bei hohen Temperaturen im Bereich von zum Beispiel 2200 bis 2500 °C auf. Ferner kann sich eine inhomogene Heizwirkung bilden, da sich der Tiegel trotz gleichförmiger Energiezufuhr vom Boden zur Tiegelöffnung hin tendenziell weniger stark erwärmt.

Ein weiterer Nachteil der herkömmlichen Verdampferzelle ergibt sich daraus, dass zur Verbesserung eines störungsfreien Betriebs ohne eine gegenseitige Beeinflussung der Widerstands- und Elektronenstrahlheizungen zwei Regelkreise realisiert werden. Dies kann wegen der Komplexität des Aufbaus und erhöhter Kosten von Nachteil sein. Schließlich hat sich beim Dauerbetrieb der herkömmlichen Verdampferzelle gezeigt, dass der für die Regelung verwendete Temperatursensor unter der Wirkung der hohen Betriebstemperatur ausfallen kann. Nach einem Sensorausfall kann eine aufwendige Demontage der Verdampferzelle erforderlich sein.

Weitere Verdampferzellen sind aus WO 2006/043723 A1, US 5 016 566 A, US 5 944 903 A, EP 0 122 088 A1, US 3 281 517 A, EP 1 732 129 A2 und der Publikation von E. M. Azaroual et al. in "J. Phys. III. France" Band 2, 1992, S. 899-904 bekannt.

Die Aufgabe der Erfindung ist es, eine verbesserte Verdampferzelle zur Überführung insbesondere von hochschmelzenden Materialien in die Gasphase, insbesondere eine verbesserte Effusionszelle bereitzustellen, mit der Nachteile der herkömmlichen Verdampferzelle überwunden werden und die insbesondere einen dauerhaften und zuverlässigen Betrieb bei hohen Temperaturen, z. B. oberhalb von 1900°C ermöglicht. Die Aufgabe der Erfindung besteht auch in der Bereitstellung eines verbesserten Verfahrens zur Verdampfung insbesondere von hochschmelzenden Materialien, mit dem Nachteile herkömmlicher Techniken überwunden werden.

Diese Aufgaben werden durch eine Verdampferzelle mit den Merkmalen von Anspruch 1 gelöst. Vorteilhafte Ausführungsformen und Anwendungen der Erfindung ergeben sich aus den abhängigen Ansprüchen.

Vorrichtungsbezogen basiert die Erfindung insbesondere auf der technischen Lehre, eine Verdampferzelle mit einem Tiegel und einem Heizwiderstand bereitzustellen, der eine Vielzahl von Heizbereichen zur Widerstands- und/oder Elektronenstrahlheizung des Tiegels umfasst. Im Unterschied zu der herkömmlichen Verwendung einer Heizwendel mit in Reihe geschalteten Heizelementen bilden die Heizbereiche der erfindungsgemäßen Verdampferzelle auf einer Außenseite des Tiegels eine elektrische Parallelschaltung. Die Heizbereiche sind dazu vorgesehen, elektrisch parallel an Anschlüsse einer Spannungsversorgung für die Widerstands- und Elektronenstrahlheizung angeschlossen zu werden. Der Tiegel weist eine Axialrichtung auf, die einer Verbindungslinie zwischen einem Tiegelboden und einer Tiegelöffnung entspricht. Die Parallelschaltung erstreckt sich in der Axialrichtung des Tiegels. Bei Beaufschlagung der Heizbereiche mit einer Heizspannung fließt ein Heizstrom parallel und gleichsinnig durch alle Heizbereiche.

Die Parallelschaltung der Heizbereiche bietet eine Reihe von Vorteilen. Erstens wird an jedem der Anschlüsse, z. B. beim Tiegelboden oder bei der Tiegelöffnung, nur ein Kontakt zur Verbindung der Heizbereiche mit der Spannungsversorgungseinrichtung benötigt. Die Befestigung der Heizeinrichtung auf der Außenseite des Tiegels wird vereinfacht. Die Befestigung kann insbesondere realisiert werden, ohne dass elektrische Isolatoren in Bereichen besonders hoher Temperatur, d.h. nahe der Tiegelöffnung erforderlich sind. Des weiteren werden eventuelle Variationen des elektrischen Widerstandes im Material der Heizbereiche durch die Parallelschaltung ausgeglichen. Somit ergibt sich eine erhöhte Gleichförmigkeit der Tiegelheizung. Schließlich haben die Erfinder festgestellt, dass die Vermeidung unerwünschter Magnetfelder nicht nur mit der herkömmlichen Heizwendel, sondern auch mit der Parallelschaltung der Heizbereiche erzielt werden kann, in dem an der Verdampferzelle Bereiche mit einer Stromrichtung bereitgestellt werden, die zu der Stromrichtung in den Heizbereichen umgekehrt ist. Dies kann zum Beispiel mit Teilen einer Abschirmeinrichtung (siehe unten) oder einem zusätzlichen Leiter realisiert werden.

Verfahrensbezogen wird beschrieben, Verdampfungsgut in einem Tiegel einer Verdampferzelle einer indirekten Heizung mit einer außerhalb des Tiegels angeordneten Gruppe von parallel geschalteten Heizbereichen zu unterziehen, die in einem ersten Temperaturbereich eine Widerstandsheizung und in einem zweiten Temperaturbereich eine Elektronenstrahlheizung des Tiegels bilden.

Vorzugsweise wird Verdampfungsgut verdampft, das ein hochschmelzendes Material umfasst. Hochschmelzendes Material zeichnet sich durch einen Schmelzpunkt oberhalb von 1500°C, insbesondere oberhalb von 2000°C aus.

Ein besonderer Vorteil der Erfindung besteht darin, dass die Verdampferzelle im Vergleich zur herkömmlichen Verdampferzelle einen vereinfachten Aufbau aufweist und einen zuverlässigen Dauerbetrieb ermöglicht, ohne dass die hervorragenden Eigenschaften der Verdampferzelle insbesondere in Bezug auf die Temperatureinstellung beeinträchtigt werden.

Die erfindungsgemäße Verdampferzelle stellt vorzugsweise eine Effusionszelle dar. Sie ist insbesondere zur genauen und reproduzierbaren Abscheidung von Schichten aus hochschmelzenden Materialien, z. B. in der Halbleitertechnik geeignet. Mit der Verdampferzelle werden Temperaturen oberhalb von 2000 °C, z. B. oberhalb von 2300 °C, insbesondere bis nahezu 3000 °C, z. B. bis 2900 °C erreicht. Ein weiterer Vorteil der Erfindung besteht darin, dass mit einer einzigen Heizeinrichtung der erfindungsgemäße Verdampferzelle eine Temperatureinstellung in einem Temperaturbereich ermöglicht wird, der von Raumtemperatur (oder sogar darunter) bis zu den genannten hohen Temperaturen reicht.

Die erfindungsgemäße Verdampferzelle weist einen erweiterten Anwendungsbereich auf. Sie kann bspw. zum Dauerbetrieb gemeinsam mit einer Vielzahl weiterer Verdampferzellen in einer Beschichtungsanlage verwendet werden, wobei die Verdampferzellen ohne eine gegenseitige Beeinflussung gesteuert werden können und einen geringen Wartungsaufwand aufweisen.

Im Folgenden wird das zu bearbeitende Material unabhängig von der konkreten Aufgabe der Verdampferzelle und unabhängig von der Art des Phasenübergangs als Verdampfung oder Sublimation als "Verdampfungsgut" bezeichnet. Entsprechend wird der Übergang in die Gasphase im Folgenden unabhängig von der Tatsache, ob im konkreten Fall eine Verdampfung aus der Schmelze oder eine Sublimation aus dem Festzustand erfolgt, als "Verdampfung" bezeichnet.

Die parallel geschalteten Heizbereiche zur kombinierten Widerstandsheizung und Elektronenstrahlheizung erstrecken sich gemäß der Erfindung auf mehreren Seiten des Tiegels, so dass vorteilhafterweise die Genauigkeit und Reproduzierbarkeit der Temperatureinstellung verbessert werden kann. Der Tiegel umfasst typischerweise den Tiegelboden und eine Seitenwand, die einen Innenraum des Tiegels einschließt. Gemäß bevorzugten Merkmalen kann der Tiegel die Form eines Zylinders, z. B. mit einer kreisförmigen oder elliptischen Grundfläche oder die Form eines Konus aufweisen. Die Verteilung der Heizbereiche auf mehreren Seiten des Tiegels bedeutet, dass die Heizbereiche (oder Heizwiderstandsabschnitte) auf der Außenseite der Seitenwand verteilt angeordnet sind. Insbesondere zur Verdampfung größerer Mengen von Verdampfungsgut ist vorzugsweise vorgesehen, dass der Tiegel eine lang gestreckte Form aufweist. Die charakteristische Größe (z. B. der Durchmesser) des Tiegelbodens ist geringer als die Ausdehnung (z. B. Höhe der Seitenwände). Erfindungsgemäß erstrecken sich die Heizbereiche entlang der Längsausdehnung (Axialrichtung) auf der Außenseite des Tiegels.

Die Heizbereiche können Heizelemente umfassen, die entlang der Axialrichtung des Tiegels voneinander getrennt verlaufen (keine Ausführungsform der Erfindung). Die Heizelemente sind zwischen den in Axialrichtungen beabstandet angeordneten Anschlüssen des Heizwiderstandes parallel geschaltet. Die Verwendung der voneinander beabstandet angeordneten Heizelemente hat den Vorteil, dass während des Betriebs der Verdampferzelle eine Beobachtung des Tiegels, z.B. für Zwecke der Überwachung oder der Temperaturmessung mit optischen Mitteln ermöglicht wird. Des weiteren ermöglichen die Heizelemente die Bereitstellung eines relativ hohen Widerstandswertes des Heizwiderstands. Schließlich wird mit jedem Heizelement, das vorzugsweise entlang der Axialrichtung des Tiegels mit einem konstanten Querschnitt gebildet ist, ein konstanter Widerstand pro Länge bereitgestellt. Vorteilhafterweise kann somit eine in der Axialrichtung des Tiegels konstante Heizleistung erzeugt werden.

Gemäß einer Variante weist die Heizeinrichtung einen oberen Ringleiter auf, an dem die Heizelemente (oder: Heizleiter) parallel angeschlossen sind. Der obere Ringleiter umfasst allgemein einen elektrischen Leiter, der den Tiegel an einem oberen Ende, d.h. an dem Ende mit der Tiegelöffnung umgibt. Mit dem oberen Ringleiter sind alle Heizelemente mit einem ersten (oberen) Ende verbunden.

Die Anordnung des oberen Ringleiters bei der Tiegelöffnung bedeutet, das der obere Ringleiter mit einem radialen Abstand die Tiegelöffnung azimutal umgibt. Alternativ kann der obere Ringleiter mit einem axialen Abstand vor der Tiegelöffnung angeordnet sein. Zur Vermeidung eines Niederschlags von Verdampfungsgut auf dem oberen Ringleiter ist dieser allerdings vorzugsweise außerhalb der Verdampfungscharakteristik des Tiegels angeordnet. Gemäß einer weiteren Alternative kann der obere Ringleiter mit einem Abstand entgegengesetzt zur Verdampfungsrichtung die Seitenwand des Tiegels hinter der Tiegelöffnung umgeben. Dies ist insbesondere dann möglich, wenn die Gefahr eines Niederschlags von Verdampfungsgut an der Tiegelöffnung gering ist. An die Form des Ringleiters werden keine besonderen Anforderungen gestellt. Er kann beispielsweise die gleiche Form wie die Querschnittsform des Tiegels (z. B. kreisförmig, elliptisch) oder alternativ eine andere Form mit geraden oder gekrümmten Leiterabschnitten (z. B. mehreckig) haben.

Der obere Ringleiter ist dazu vorgesehen, mit einem ersten Potential beaufschlagt zu werden. Der obere Ringleiter ist vorzugsweise mit dem negativen Pol der Spannungsversorgungseinrichtung, insbesondere mit dem negativen Pol der Stromquelle für die Widerstandsheizung und der Hochspannungsquelle für die Elektronenstrahlheizung verbunden.

Gemäß einer weiteren Variante weist die Heizeinrichtung einen unteren Ringleiter auf, an dem die Heizelemente parallel angeschlossen sind. Die zweiten (unteren) Enden der Heizelemente sind mit dem unteren Ringleiter verbunden. Der untere Ringleiter ist dazu eingerichtet, mit einem zweiten Potential beaufschlagt zu werden. Der untere Ringleiter umfasst allgemein einen elektrischen Leiter, der den Tiegel an einem unteren Ende, d. h. an dem Ende mit dem Tiegelboden umgibt. Vorzugsweise weist der untere Ringleiter die gleiche axiale Position wie der Tiegelboden auf. Alternativ kann er mit einem axialen Abstand unterhalb des Tiegelbodens angeordnet sein, wobei er eine Halterungseinrichtung des Tiegels umgibt. In diesem Fall kann die zuverlässige Heizung des gesamten Tiegelbodens verbessert werden. Gemäß einer weiteren Alternative kann der untere Ringleiter vom Tiegelboden in Verdampfungsrichtung, d.h. in Richtung hin zur Verdampfungsöffnung versetzt angeordnet sein, wenn an die Heizung des Tiegelbodens geringere Anforderungen gestellt werden.

Vorteilhafterweise kann der obere Ringleiter oder der untere Ringleiter vorgesehen sein, um das gemeinsame Potential für die oberen oder unteren Enden der Heizelemente bereitzustellen. In diesem Fall sind die anderen Enden der Heizelemente, d. h. die unteren oder die oberen Enden der Heizelemente nicht mit einem gemeinsamen Leiter, sondern über getrennte Leiter mit einem Pol der Strom- und Hochspannungsquellen verbunden. Die Bereitstellung von nur einem der oberen und unteren Ringleiter kann in Abhängigkeit von der konkreten Bauform der Verdampferzelle von Vorteil sein.

Vorteile hat auch eine Variante, bei welcher der obere Ringleiter und der untere Ringleiter vorgesehen sind, zwischen denen sich die Heizelemente erstrecken. Vorteilhafterweise wird damit eine besonders stabile Anordnung der Heizelemente erzielt. Die Ringleiter übernehmen wegen der Bereitstellung des gemeinsamen Potentials für die Heizelemente und der Halterung der Heizelemente eine mechanische und elektrische Doppelfunktion.

Gemäß der Erfindung berühren sich die Heizbereiche in Umfangsrichtung des Tiegels gegenseitig. Die Heizbereiche sind zu einem flächigen Widerstandsmaterial verbunden, das den Tiegel teilweise oder radial allseitig umgibt. Die Heizbereiche bilden eine Widerstandshülse (Heizfolie), die den Tiegel radial allseitig umgibt. Die Form der Widerstandshülse ist konusförmig gebildet.

Durch eine konische Form der Widerstandshülse kann vorteilhafterweise bevorzugt ein vorderer oder hinterer Teil des Tiegels erwärmt werden. Bei konstantem Strom durch die Hülse und bei konstanter Dicke des Hülsenmaterials (z. B. 10 µm) wird die Hülse an ihrem geringsten Querschnitt am stärksten erwärmt. Diese Eigenschaft der Hülse ist ein wesentlicher Vorteil, da diese Temperaturvariation mit einzelnen Filamenten konstanten Querschnitts nicht erreichbar ist.

Gemäß der Erfindung bilden die Heizbereiche einen einzigen, den Tiegel umgebenden, flächigen Heizleiter. Die hat den besonderen Vorteil, dass das flächige Widerstandsmaterial eine im Vergleich zu den einzelnen, voneinander beabstandeten Heizelementen erhöhte Stabilität aufweist. Mit der erhöhten Stabilität wird eine verbesserte Homogenität der Erwärmung des Tiegels, insbesondere bei der Elektronenstrahlheizung erzielt.

Gemäß der Erfindung weist das flächige Widerstandsmaterial, insbesondere die Widerstandshülse in der Axialrichtung des Tiegels eine konstante Dicke auf. Diese Variante ist insbesondere bei Verwendung einer konusförmigen Widerstandshülse von Vorteil. Die konusförmige Widerstandshülse weist eine sich von der Tiegelöffnung zum Tiegelboden verringernde Querschnittsdimension auf. Wegen der in Axial- und Azimutalrichtung konstanten Dicke des Widerstandsmaterials nimmt der integrierte Querschnitt der Widerstandshülse von der Tiegelöffnung zum Tiegelboden ab. Somit ist von der Tiegelöffnung zum Tiegelboden ein zunehmender elektrischer Widerstand gegeben (Widerstandsgradient). Daher kann in Axialrichtung des Tiegels von der Tiegelöffnung zum Tiegelboden ein Gradient der Heizleistung realisiert werden.

Gemäß einem bevorzugten Merkmal der Erfindung weist die Widerstandshülse an ihrem oberen Rand, der die Tiegelöffnung umgibt, und/oder an ihrem unteren Rand, der den Tiegelboden umgibt, in radialer Richtung nach außen gebogene oder geknickte Streifen auf, die zur Befestigung der Widerstandshülse jeweils entsprechend an einem oberen und/oder unteren Ringleiter und zum Ausgleich thermischer Änderungen der Länge der Widerstandshülse vorgesehen sind.

Typischerweise hat der Tiegel an der Tiegelöffnung durch Abstrahlung einen stärkeren Wärmeverlust als am Tiegelboden. Dadurch entsteht bei konstanter Heizleistung ein Temperaturgradient, der in Abhängigkeit von der konkreten Anwendung, insbesondere in Abhängigkeit von dem verdampften Material unerwünscht sein kann. Die Bildung eines Gradienten der Heizleistung kann vorteilhafterweise genutzt werden, um den Temperaturgradienten zu kompensieren oder in vorbestimmter Weise einzustellen.

Der genannte Widerstandsgradient wirkt sich besonders vorteilhaft bei der Elektronenstrahlheizung aus. Wenn negatives Potential am oberen Ende der Widerstandshülse nahe der Tiegelöffnung anliegt, erfahren injizierte Elektronen den elektrischen Widerstand einerseits der Vakuumstrecke zum Tiegel und andererseits des Stromweges durch die Widerstandshülse. Mit dem Widerstandsgradienten kann sich das Verhältnis beider Widerstandswerte in Axialrichtung des Tiegels verändern. Nahe der Tiegelöffnung erfolgt eine stärkere Elektronenstrahlheizung als nahe dem Tiegelboden so dass der Temperaturgradient eingestellt werden kann, um die Strahlungsverluste am oberen Tiegelende zu kompensieren.

Gemäß einer besonders bevorzugten Variante der Erfindung bilden die Heizbereiche eine Metallfolie, die sich zwischen Anschlüssen des Heizwiderstands erstreckt, die in Axialrichtung des Tiegels auf dessen Außenseite voneinander beabstandet angeordnet sind. Die Metallfolie hat vorzugsweise eine Dicke im Bereich von 5 µm bis 50 µm, insbesondere 15 µm bis 50 µm oder bevorzugt 5 µm bis 30 µm, z. B. 5 µm bis 8 µm.

Gemäß einer weiteren Variante der Erfindung können der obere Ringleiter und/oder der untere Ringleiter, die oben beschrieben wurden, auch an der Widerstandshülse vorgesehen sein. Der obere Ringleiter und/oder der untere Ringleiter können z. B. an den Enden der Widerstandshülse auf deren Außenseite oder auf deren Randkante befestigt, z. B. angeschweißt sein.

Erfindungsgemäß können Heizbereiche, die getrennte Heizelemente umfassen, und Heizbereiche, die zu einem flächigen Widerstandsmaterial verbunden sind und den Tiegel teilweise umgeben, kombiniert werden. In diesem Fall können sich Vorteile für die Bereitstellung einer bestimmten Verteilung der Heizleistung am Tiegel ergeben.

Da die Parallelschaltung der Heizbereiche deren Halterung am Tiegel vereinfacht, kann gemäß einer weiteren Variante der Erfindung vorgesehen sein, dass der Heizwiderstand über einen elektrischen Isolator mit dem Tiegel fest verbunden ist. Der elektrische Isolator, der eine Vielzahl von Isolatorelementen oder bevorzugt einen einzigen Isolatorring umfasst, ist auf einer Außenseite des Tiegels vorzugsweise in einem Teilbereich angeordnet, in dem eine geringere Temperatur als in anderen Bereichen des Tiegels herrscht.

Bei Bereitstellung des unteren Ringleiters wird dieser an dem elektrischen Isolator angebracht, der mit dem Tiegel, insbesondere dem Tiegelboden fest verbunden ist. Durch die Kombination des elektrischen Isolators mit dem unteren Ringleiter wird eine zuverlässige Halterung der Heizelemente gebildet. Bei Bereitstellung des flächigen Widerstandsmaterials wird dessen unterer Rand an dem elektrischen Isolator befestigt.

Vorteilhafterweise kann die thermische Belastung des elektrischen Isolators noch vermindert werden, wenn dieser an einer Halteeinrichtung des Tiegels, d.h. relativ zu der axialen Bezugsrichtung des Tiegels unterhalb des Tiegelbodens befestigt ist. Der untere Ringleiter oder der untere Rand des flächigen Widerstandsmaterials ist in diesem Fall über einen Ringhalter mit dem elektrischen Isolator verbunden. Der Ringhalter überbrückt den Abstand zwischen dem Heizwiderstand am Tiegelboden und der Position des elektrischen Isolators an der Halteeinrichtung.

Der Ringhalter kann einen mechanischen Träger des Heizwiderstands bilden. In diesem Fall besteht er aus einem elektrisch isolierenden Material. Alternativ kann der Ringhalter eine elektrische Leitung zur Beaufschlagung des Heizwiderstands mit dem zweiten Potential bilden. In diesem Fall besteht der Ringhalter aus einem elektrisch leitfähigen Material, wobei sich der integrierte Materialquerschnitt des Ringhalters vorzugsweise von dem Durchmesser der Heizelemente oder der Dicke der Widerstandshülse so unterscheidet, dass bei der Widerstandsheizung ein geringer elektrischer Widerstand und somit praktisch keine Aufheizung und bei der Elektronenstrahlheizung praktisch keine Elektronenemission realisiert werden. Der Ringhalter kann z. B. einen Ring aus einer Metallfolie oder einem Blech, Haltestifte oder Stanz- oder Frästeile umfassen.

Die Bereitstellung des elektrischen Isolators an der Halteeinrichtung hat den Vorteil, dass die Halteeinrichtung nicht nur von der indirekten Heizung ausgenommen ist, sondern sogar aktiv direkt gekühlt werden kann, so dass eine unerwünschte thermische Beanspruchung des elektrischen Isolators ausgeschlossen wird.

Gemäß einer weiteren vorteilhaften Variante der Erfindung weist die Verdampferzelle eine Abschirmeinrichtung mit einer Abschirmwand auf, die den Tiegel in radialer Richtung umgibt. Die Abschirmwand kann vorteilhafterweise mehrere Funktionen erfüllen. Erstens kann eine thermische Abschirmung der Umgebung der Verdampferzelle realisiert werden, was insbesondere für die unabhängige Steuerung von mehreren benachbarten Verdampferzellen in einer Beschichtungsanlage von Vorteil ist. Zweitens kann die Abschirmwand einen mechanischen Träger für die Heizeinrichtung, insbesondere der Heizbereiche und ggf. einen der Ringleiter bilden.

Ein besonderer Vorteil der Erfindung ergibt sich daraus, dass die Heizbereiche mit einem Ende, vorzugsweise mit dem oberen Ende, d.h. in der Umgebung der Tiegelöffnung mit der Abschirmwand elektrisch verbunden sein können. Im Unterschied zu der herkömmlichen Verdampferzelle ist ein elektrischer Isolator im oberen Bereich des Tiegels, insbesondere in der Umgebung der Tiegelöffnung nicht erforderlich. Über die Abschirmwand kann die elektrische Verbindung der oberen Enden der Heizbereiche (ggf. mit dem oberen Ringleiter) mit einem Pol der Stromquelle oder Hochspannungsquelle hergestellt werden. Die Heizbereiche (ggf. der obere Ringleiter oder der obere Rand des flächigen Widerstandsmaterials) können direkt an der Abschirmwand befestigt sein. Damit wird der Aufbau der erfindungsgemäßen Verdampferzelle erheblich vereinfacht.

Gemäß einer weiteren vorteilhaften Variante der Erfindung können die Heizbereiche so angeordnet sein, dass der radiale Abstand der oberen Enden der Heizbereiche vom Tiegel, insbesondere von der Tiegelöffnung größer ist als der radiale Abstand der unteren Enden der Heizbereiche vom Tiegel, insbesondere vom Tiegelboden. Der radiale Abstand der oberen Enden der Heizbereiche von der Tiegelöffnung ist vorzugsweise im Bereich von 1 mm bis 6 mm gewählt. Der radiale Abstand der unteren Enden der Heizbereiche vom Tiegelboden ist vorzugsweise im Bereich von 1 mm bis 4 mm gewählt.

Mit Heizbereichen, die sich in Längsrichtung gerade erstrecken, ergibt sich ein Abstandsgradient von der Tiegelöffnung hin zum Tiegelboden. Durch den abnehmenden radialen Abstand sinkt der Widerstand der Vakuumstrecke von den Heizbereichen zur Seitenwand des Tiegels. Damit kann vorteilhafterweise das oben genannte Verhältnis der Widerstandswerte über die Vakuumstrecke und durch die Heizbereiche zusätzlich beeinflusst werden, um den Temperaturgradienten in Axialrichtung zu kompensieren oder einzustellen und/oder die Temperatur-Emissionsregelung zu beeinflussen.

Alternativ kann vorgesehen sein, dass der Heizwiderstand bei der Tiegelöffnung einen geringeren radialen Abstand von der Seitenwand aufweist als bei dem Tiegelboden. Vorteilhafterweise kann damit die Heizleistung nahe dem Tiegelboden im Vergleich zur Heizleistung nahe der Tiegelöffnung verringert werden.

Zusätzlich zu dem Abstandsgradienten ist gemäß der Erfindung ein Widerstandsgradient vorgesehen, mit dem der Ohm'sche Widerstand der Heizbereiche bei der Tiegelöffnung geringer als beim Tiegelboden ist. Der Widerstandsgradient wird wie oben beschrieben durch die Konusform des Heizwiderstands erhalten.

Es kann vorgesehen sein, dass der Heizwiderstand bei der Tiegelöffnung einen größeren Widerstandswert aufweist als bei dem Tiegelboden. Vorteilhafterweise ist damit eine weitere Möglichkeit gegeben, bei Bedarf die Heizleistung nahe dem Tiegelboden kleiner einzustellen als die Heizleistung nahe der Tiegelöffnung.

Besonders bevorzugt ist eine Variante der Erfindung, bei der sich die Heizbereiche, insbesondere die Heizelemente zwischen dem oberen Ringleiter und dem unteren Ringleiter oder das flächige Widerstandsmaterial, freitragend erstrecken. Dabei kann der untere Ringleiter oder der untere Rand des flächigen Widerstandsmaterials unmittelbar oder über die genannten Haltestifte am elektrischen Isolator befestigt sein, der am Tiegelboden oder der Halteeinrichtung angeordnet ist, während der obere Ringleiter oder der obere Rand des flächigen Widerstandsmaterials in der Umgebung der Tiegelöffnung an der Innenseite der Abschirmwand befestigt sein kann. Bei einem zylindrischen Aufbau mit einem Tiegel in Form eines geraden Zylinders und einer Abschirmwand in Form einer geraden, zylinderförmigen Hülse wird somit der genannte Abstandsgradient mit dem in Verdampfungsrichtung zunehmenden radialen Abstand der Heizelemente vom Tiegel realisiert.

Gemäß einer weiteren vorteilhaften Variante der Erfindung ist die Verdampferzelle mit mindestens einer Temperaturmesseinrichtung ausgestattet, mit der eine Betriebstemperatur der Verdampferzelle erfassbar ist. Dies bietet insbesondere den Vorteil, dass die Temperaturmessung einfach für verschiedene Messprinzipien eingerichtet werden kann. Vorzugsweise umfasst die Temperaturmesseinrichtung ein Thermoelement, ein Bolometerelement und/oder ein Pyrometerelement. Das Thermoelement hat den Vorteil einer unmittelbaren und kostengünstigen Temperaturmessung, während die optische Temperaturmessung mit Pyrometer- oder Bolometerelementen Vorteile in Bezug auf die berührungslose Messung über relativ große Messabstände haben.

Wegen der einfachen Kalibrierbarkeit und des geringen Platzbedarfs wird jedoch das Thermoelement zur Temperaturmessung bevorzugt. In dem interessierenden Bereich hoher Temperaturen sind Thermoelemente, insbesondere auf der Basis von Wolfram und Rhenium verfügbar (siehe z. B. R. R. Asamoto et al. in "The Review of Scientific Instruments", Bd. 38, 1967, S. 1047). Für die optische Temperaturmessung ist vorzugsweise außerhalb der Verdampferzelle ein Strahlungsdetektor vorgesehen, mit dem ggf. durch ein Sichtfenster oder eine Öffnung in einer Abschirmeinrichtung eine von der Außen- oder Innenwand des Tiegels ausgehende, temperaturabhängige Wärmestrahlung erfassbar ist.

Wenn gemäß einer weiteren Variante der Erfindung das Thermoelement mit einem axialen Abstand unterhalb des Tiegelbodens in der axialen Bezugsrichtung des Tiegels verschiebbar ist, können mehrere Vorteile erzielt werden. Erstens kann durch eine einfache Verschiebung der axiale Abstand des Thermoelements vom Tiegelboden eingestellt und damit an die konkreten Betriebsbedingungen der Verdampferzelle angepasst werden. Des weiteren kann das Thermoelement, z. B. für Zwecke der Wartung oder des Austauschs leicht von der Verdampferzelle entfernt werden, ohne dass eine aufwendige Demontage erforderlich ist. Hierzu weist das Thermoelement vorzugsweise eine gerade Bauform auf. Dies ermöglicht, dass das Thermoelement durch einen geraden Kanal durch die Halteeinrichtung des Tiegels und ggf. weitere Komponenten der Verdampferzelle bis zur gewünschten Position unterhalb des Tiegelbodens vorgeschoben werden kann. Der optimale axiale Abstand vom Tiegelboden kann zum Beispiel durch Testreihen oder durch eine vorherige Kalibrierungsmessung ermittelt werden.

Gemäß einer weiteren vorteilhaften Merkmal der Erfindung ist die Halteeinrichtung der Verdampferzelle zur thermisch isolierten Positionierung des Tiegels relativ zu den anderen Teilen der Verdampferzelle und insbesondere relativ zu einem Träger eingerichtet. Die Halteeinrichtung stellt eine mechanische Halterung dar, welche die äußere Oberfläche des Tiegels im Wesentlichen freilässt, wenn dieser aus einem elektrisch leitfähigen Material gebildet ist. Vorzugsweise ist die Halteeinrichtung in diesem Fall am Tiegelboden vorgesehen, so dass die Seitenwände des Tiegels für die Wärmeübertragung von der Heizeinrichtung freiliegen. Wenn die Halteeinrichtung aus einem elektrisch leitfähigen Material besteht, kann sie vorteilhafterweise neben der mechanischen Halterung gleichzeitig als Hochspannungskontakt für den Tiegel dienen. Wenn der Tiegel aus einem elektrisch nicht leitfähigen Material besteht, ist die Halteeinrichtung so geformt, dass sie den größten Teil der Außenfläche des Tiegels überdeckt. In diesem Fall ist vorzugsweise eine formschlüssige Verbindung zwischen der Außenfläche des Tiegels und der Innenseite der Halteeinrichtung vorgesehen.

Wenn die Halteeinrichtung durch ein Bauteil mit einem Hohlprofil gebildet wird, können sich Vorteile für die Verminderung der Wärmeleitung vom Tiegel zur Umgebung und für eine stabile Positionierung des Tiegels auch bei extrem hohen Temperaturen ergeben. Die Halteeinrichtung ist bspw. ein Hohlzylinder oder ein Hohlkonus, der an der Unterseite des Tiegels angebracht ist. Die zylinder- oder konusförmige Halteeinrichtung weist eine besonders hohe mechanische Stabilität auf. Der Tiegel wird steif und vollflächig mit einem Schutz gegen Torsion und Verbiegung gehalten.

Vorteilhafterweise wird durch das Hohlprofil, das den Hochspannungskontakt des Tiegels bildet, in unmittelbarer Umgebung des Tiegels ein Raum geschaffen, in dem die Betriebstemperatur des Tiegels messbar ist und in dem eine reduzierte Feldstärke gegeben ist. Daher ist die Temperaturmesseinrichtung vorzugsweise zur Temperaturmessung im Inneren der Halteeinrichtung vorgesehen. Die Halteeinrichtung weist zum Beispiel eine axiale Öffnung auf, durch welche das Thermoelement in die Halteeinrichtung einführbar ist. Die Positionierung des Thermoelements im Hohlprofil der Halteeinrichtung hat den besonderen Vorteil, dass eine allseitige Abschirmung des Thermoelements insbesondere gegen die hohen Feldstärken beim Betrieb der Heizeinrichtung als Elektronenstrahlheizung erreicht wird und unerwünschte Hochspannungsüberschläge vermieden werden.

Vorzugsweise ist an dem Träger eine Aufnahme vorgesehen, in welche die Halteeinrichtung einsteckbar ist. Die Aufnahme besitzt bspw. die Form eines zylinder- oder konusförmigen Schachtes, dessen Innenform an die Außenform des Hohlprofils der Halteeinrichtung angepasst ist. Vorteilhafterweise bildet die eingesteckte Halteeinrichtung einen festen mechanischen Kontakt mit dem Träger, so dass ein Verkippen des Tiegels während des Betriebes der Verdampferzelle vermieden wird.

Vorteilhafterweise ermöglicht die erfindungsgemäße Verdampferzelle eine genaue Temperatureinstellung im Tiegel. Hierzu ist vorzugsweise eine Regeleinrichtung vorgesehen, mit der die Heizeinrichtung einstellbar ist. Die Regeleinrichtung kann die folgenden Regelkreise enthalten. Ein erster Regelkreis dient der Einstellung eines Heizstroms des Heizwiderstandes für einen Widerstandsheizbetrieb. Der zweite Regelkreis dient der Einstellung eines Elektronenstroms vom Heizwiderstand zum Tiegel für einen Elektronenstrahl-Heizbetrieb.

In den Regelkreisen wird der Heiz- und/oder Elektronenstrom des Heizwiderstandes allgemein unter Verwendung einer Istgröße geregelt, die in Abhängigkeit von der konkreten Aufgabe der Verdampferzelle gewählt ist. Beispielsweise kann eine gemessene Aufdampfrate als Istgröße für die Regelkreise verwendet werden. Bevorzugt erfolgt die Regelung in Abhängigkeit von der Betriebstemperatur des Tiegels. Hierzu ist die Temperaturmesseinrichtung mit wenigstens einem der Regelkreise verbunden.

Weitere Vorteile werden mit einer Ausführungsform der Erfindung erzielt, bei der die Regeleinrichtung einen einzigen Regelkreis aufweist, mit dem die Temperatur der Verdampferzelle einstellbar ist. Besonders bevorzugt ist der einzige Regelkreis für eine Spannungsregelung der Heizeinrichtung vorgesehen. Mit dem Regelkreis wird in Abhängigkeit von einer IstGröße, z. B. der Temperatur, die mit der Temperaturmesseinrichtung ermittelt wurde, die Spannung an den Enden der parallel geschalteten Heizelemente eingestellt. Vorteilhafterweise wird die Verdampferzelle ausschließlich über die Heizspannung der Parallelschaltung der Heizelemente geregelt.

Die Erfinder haben festgestellt, dass durch die Parallelschaltung der Heizelemente erreicht wird, dass bei einer ausreichend hohen Heizspannung, vorzugsweise im Bereich von 2 V bis 8 V, z. B. bei 4 V automatisch der Übergang von der Widerstandsheizung zur Elektronenstrahlheizung erfolgt, wobei die Leistung der Elektronenstrahlheizung passiv und mit hoher Stabilität dem Verlauf der Heizspannung folgt. Im Unterschied zur Regelung der herkömmlichen Verdampferzelle ist es nicht erforderlich, die Hochspannungsquelle zu regeln. Es wurde festgestellt, dass die Hochspannungsquelle bei Regelung der Heizspannung der Heizelemente selbst nachführend arbeitet. Überraschenderweise wurde mit dem einen Regelkreis selbst bei gleichzeitigem Widerstands- und Elektronenstrahlheizbetrieb keine oszillierende, sondern eine stabile Regelcharakteristik beobachtet.

Die bevorzugte Regelcharakteristik der Elektronenstrahlheizung zeichnet sich durch eine Temperatur-Emissionsregelung aus, bei der mit steigender Temperatur der Heizbereiche der Widerstand der Vakuumstrecke zum Tiegel stetig sinkt. Der Elektronenstrom über die Vakuumstrecke steigt mit steigender Temperatur der Heizbereiche kontinuierlich an. Hierzu im Gegensatz wäre mit einer Feld-Emissionsregelung ein sprunghafter Anstieg des Elektronenstroms gegeben. Die Temperatur-Emissionsregelung wird mit einer Beschleunigungsspannung, für die bei der gegebenen Länge der Vakuumstrecke eine FeldEmission ausgeschlossen ist (z. B. U < 500 V), und einem ausreichend hohen Elektronenstrom, bei dem die Temperatur-Emission erfolgt (z. B. I = 1 A bis 3 A), der Elektronenstrahlheizung erzielt.

Als besonders vorteilhaft hat es sich erwiesen, wenn der Tiegel und der Heizwiderstand der erfindungsgemäßen Verdampferzelle, und vorzugsweise auch die Abschirmwand der Abschirmeinrichtung vollständig aus Tantal bestehen. Obwohl Tantaloxid einen relativ niedrigen Schmelzpunkt und einen relativ hohen Dampfdruck hat, konnten die Erfinder überraschenderweise feststellen, dass selbst im Hochtemperaturbetrieb der Verdampferzelle keinerlei unerwünschtes Tantal in Schichten gefunden wurde, die mit der Verdampferzelle hergestellt wurden.

Eine Beschichtungsanlage kann mit mindestens einer erfindungsgemäßen Verdampferzelle ausgestattet sein.

Im Gegensatz zu herkömmlichen Elektronenstrahlverdampfern, bei denen typischerweise flache Tiegel vorgesehen sind, kann die Verdampferzelle in der Beschichtungsanlage mit einem relativ zur Vertikalen schräg oder sogar horizontal ausgerichteten Tiegel angeordnet sein.

Weitere Einzelheiten und Vorteile der Erfindung werden im Folgenden unter Bezugnahme auf die beigefügten Zeichnungen erläutert. Es zeigen:
- Figuren 1A und 1B:: schematische Ansichten einer Verdampferzelle (keine Ausführungsform der Erfindung);
- Figuren 2A und 2B:: schematische Ansichten einer bevorzugten Ausführungsform der erfindungsgemäßen Verdampferzelle;
- Figuren 3A und 3B:: schematische Ansichten weiterer Varianten der erfindungsgemäßen Verdampferzelle;
- Figur 4:: die erfindungsgemäße Kombination der Verdampferzelle mit einer Regeleinrichtung;
- Figur 5:: eine Kurvendarstellungen zur Illustration verschiedener Betriebszustände der erfindungsgemäßen Verdampferzelle; und
- Figuren 6A bis 6C:: Einzelheiten einer weiteren Ausführungsform einer erfindungsgemäßen Verdampferzelle.

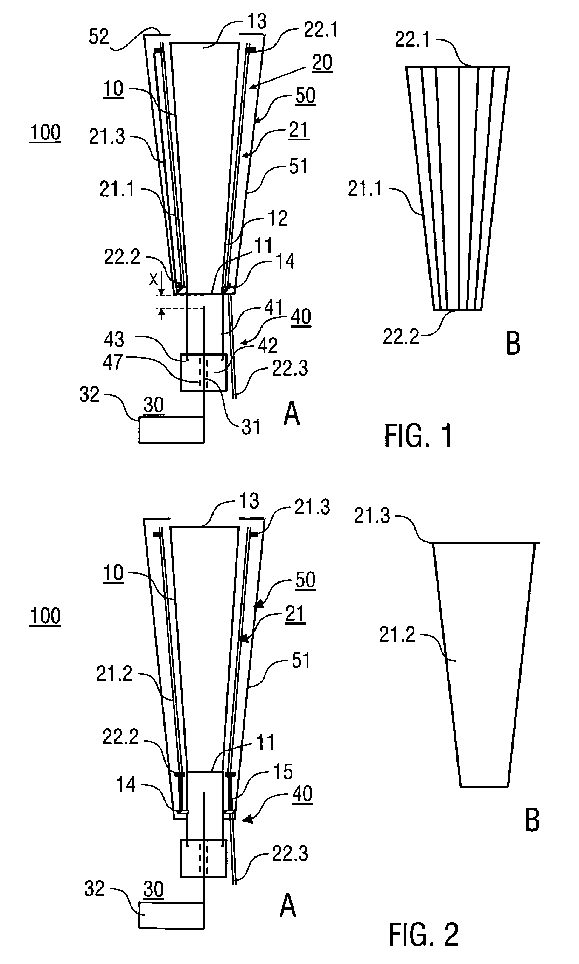

Die in Figur 1A in schematischer Schnittansicht gezeigte Verdampferzelle 100 umfasst einen Tiegel 10, einen Heizwiderstand 21 einer Heizeinrichtung 20, eine Temperaturmesseinrichtung 30, eine Halteeinrichtung 40 und eine Abschirmeinrichtung 50 (keine Ausführungsform der Erfindung). Der Heizwiderstand 21 umfasst parallel geschaltete Heizbereiche, die durch getrennt verlaufende Heizelemente 21.1 gebildet werden.

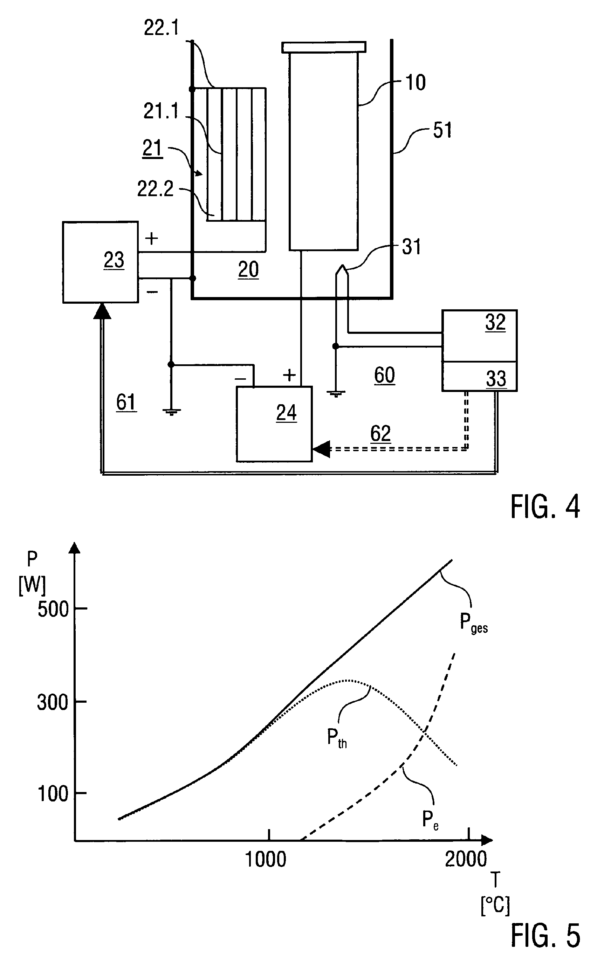

Der Tiegel 10 zur Aufnahme von Verdampfungsgut mit einem Tiegelboden 11, einer umlaufenden Seitenwand 12 und einer Austrittsöffnung 13 weist eine Konusform mit einem sich vom Tiegelboden 11 zur Austrittsöffnung 13 vergrößernden Durchmesser auf. Der Tiegel 10 besteht aus einem ein- oder mehrlagigen Material, das bis zu einer Temperatur von 3000 °C formbeständig und mechanisch stabil ist. Der Tiegel 10 kann vollständig aus einem Metallblech oder aus einer Zusammensetzung mit einem nicht-elektrisch leitfähigen Grundkörper und einer metallischen Beschichtung bestehen, wobei zum Verdampferbetrieb der elektrisch leitfähige Teil des Tiegels 10 jeweils mit einer Hochspannungsquelle 24 (siehe Figur 4) verbunden ist. Der Tiegel 10 besteht bspw. komplett aus Tantal oder aus einer Tantal-Wolfram-Kombination oder einer Wolfram-Rhenium-Legierung. Die Wolfram-Tantal-Kombination umfasst bspw. einen Aufbau mit dem Tiegelboden 11 aus Wolfram und der Seitenwand 12 aus Tantal oder einen zweilagigen Aufbau mit einem inneren Wolfram-Konus und einem äußeren Tantal-Konus. Die letztere Variante hat den Vorteil, dass das äußere Tantalblech den inneren Wolframkonus mechanisch stabilisiert. Die Maße des Tiegels 10 betragen für ein Innenvolumen von rd. 10 cm³ z. B.: Durchmesser des Tiegelbodens: 1 cm, axiale Länge des Tiegels 10: rd. 10 bis 15 cm, Durchmesser der Austrittsöffnung 13: rd. 1.5 cm.

Die Temperaturmesseinrichtung 30 umfasst ein Thermoelement 31, dessen Kontaktstelle unterhalb des Tiegelbodens 11 angeordnet und mit einem Messwandler 32 verbunden ist. Das Thermoelement ist bspw. ein Wolfram-Rhenium-Thermoelement, wie es in der o. g. Publikation von R. R. Asamoto et al. beschrieben ist. Der Messwandler 32 ist bspw. vom Typ "Eurotherm 2604".

Die Halteeinrichtung 40 umfasst einen Hohlzylinder 41 aus einem temperaturbeständigen Material, z. B. Tantal mit einem axial verlaufenden Kanal 47. Durch den Kanal 47 kann das Thermoelement 31 elektrisch isoliert durch das Innere des Hohlzylinders 41 eingeführt werden. Das Thermoelement 31 ist im Kanal 44 verschiebbar, so dass der axiale Abstand X vom Tiegelboden einstellbar ist. Der axiale Abstand X wird z. B. im Bereich von 2 mm bis 15 mm eingestellt.

Der untere Rand des Hohlzylinders 41 ist mit einem Träger 42 verbunden, der ortsfest oder verstellbar in einer Beschichtungsanlage angeordnet ist. Der Träger 42 enthält eine ringförmige Aufnahme 43, in welcher der untere Rand des Hohlzylinders 41 befestigt ist. Die Halteeinrichtung 40 dient der stabilen Halterung und als elektrischer Hochspannungskontakt des Tiegels 10.

Die Halteeinrichtung 40 stellt eine thermische Isolation zwischen dem Tiegel 10 und den übrigen Teilen an der Beschichtungsanlage dar. Zur Minimierung der Wärmeleitung besteht der Hohlzylinder 41 aus einem Blech mit einer Dicke unterhalb von 500 µm, vorzugsweise kleiner als 200 µm, z. B. im Bereich von 50 µm bis 200 µm.

Die Abschirmeinrichtung 50 umfasst eine seitlich umlaufende Abschirmwand 51 und eine Abschirmkappe 52. Die Abschirmwand 51 stellt eine thermische Barriere nach außen und eine mechanische Halterung für den oberen Ringleiter 22.1 der Heizeinrichtung 20 dar. Sie besteht z. B. aus Ta-Blech mit einer Dicke von 50 µm oder mehreren Lagen einer Ta-Folie. Die Abschirmkappe 52 dient der thermischen Isolation zwischen der Verdampferzelle 100 und einem zu beschichtenden Substrat. Mit der Abschirmkappe 52 wird der Spalt zwischen dem Tiegel 10 und der Abschirmwand 51, in dem die Heizelemente 21.1 angeordnet sind, hin zum Substrat abgeschirmt. In der Mitte der Abschirmkappe 52 ist eine Öffnung vorgesehen, die den Dampfstrahl aus dem Tiegel 10 zum Substrat durchlässt. Die Öffnung wird je nach Anwendung möglichst klein gewählt (z. B. 15 mm), um die Homogenität der Temperaturverteilung im Tiegel 10 zu verbessern und die erforderliche Heizleistung zu minimieren.

Die Heizelemente 21.1 der Heizeinrichtung 20, die den Heizwiderstand 21 bilden, sind getrennte Heizleiter, die sich zwischen einem oberen Ringleiter 22.1 und einem unteren Ringleiter 22.2 erstrecken (siehe schematische Seitenansicht in Figur 1B). Des Weiteren ist eine Anschlussleitung 22.3 vorgesehen, die mit der Heizstromquelle 23 (siehe Figur 4) verbunden ist. Die Heizelemente 21.1 erstrecken sich freitragend zwischen den oberen und unteren Ringleitern 22.1, 22.2. Jedes der Heizelemente 21.1 besteht aus einem geraden Widerstandsdraht, der aus einem für Widerstandsheizungen an sich gebräuchlichen Material, wie z. B. Wolfram oder Tantal mit einem Durchmesser von z. B. 0.635 mm hergestellt ist. Die Anzahl der Heizelemente 21.1 ist beispielsweise im Bereich von 4 bis 20, besonders bevorzugt im Bereich von 6 bis 10 gewählt. Die Heizelemente 21.1 sind azimutal gleichmäßig auf dem Umfang um den Tiegel 10 verteilt angeordnet.

Gemäß einer abgewandelten Variante können die Heizelemente durch gekrümmte Widerstandsdrähte gebildet werden. Alle Widerstandsdrähte weisen in diesem Fall die gleiche Krümmung auf, so dass die Heizelemente mit gegenseitigen Abständen zwischen den oberen und unteren Ringleitern 22.1, 22.2 parallel angeschlossen werden können. Gekrümmte Heizelemente können zum Beispiel eine periodische Struktur, wie zum Beispiel eine Wellen-, Dreieck- oder Spiral-Struktur oder eine zwischen den oberen und unteren Ringleitern 22.1, 22.2 sich erstreckende Bogenstruktur aufweisen.

Die Heizelemente 21.1 sind auf der Außenseite der Seitenwand 12 mit einem radialen Abstand von deren Oberfläche angeordnet. Der radiale Abstand wird durch die Dimensionen der oberen und unteren Ringleiter 22.1, 22.2 und deren Befestigung einerseits an der Abschirmeinrichtung 50 und andererseits am Tiegel 10 bestimmt.

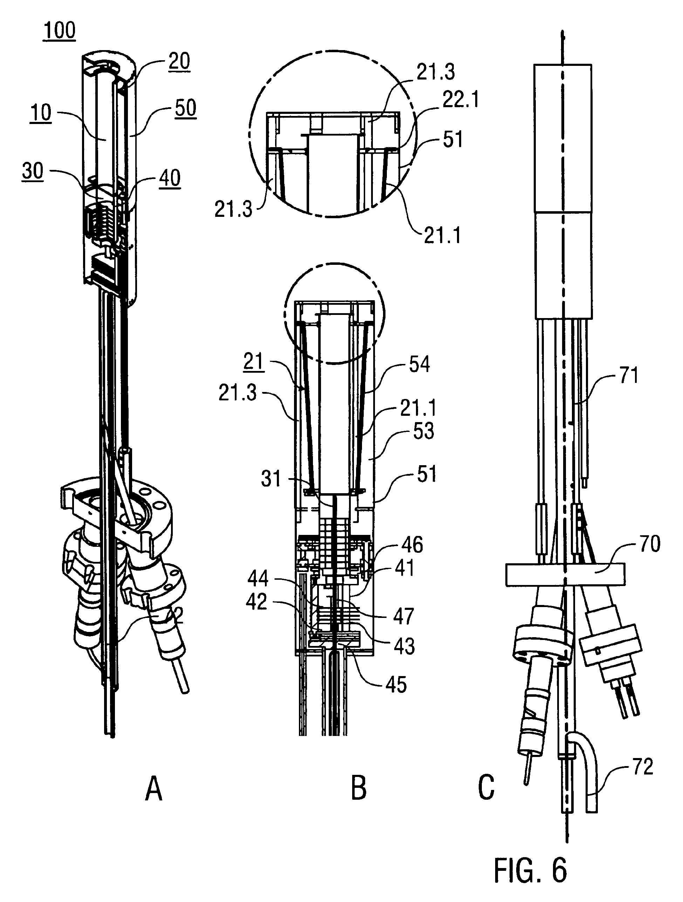

Der obere Ringleiter 22.1 ist über radial außerhalb der Heizelemente 21.1 und innerhalb der Abschirmeinrichtung 50 verlaufende Stäbe (siehe z. B. 21.3) am Isolator 14, am Träger 42 oder einem anderen ortsfesten Teil der Beschichtungsanlage befestigt (siehe auch Figur 6). Es sind mehrere Stäbe 21.3 (z. B. drei) vorgesehen, die azimutal gleichmäßig verteilt angeordnet sind. Die Stäbe 21.3 bestehen zum Beispiel aus Tantal mit einem Querschnitt von 2 bis 3 mm. Es kann eine Berührung oder ein elektrischer Kontakt der Stäbe 21.3 mit der inneren Oberfläche der Abschirmwand 51 vorgesehen sein, die zum Beispiel durch Tantal gebildet wird.

Die Abschirmeinrichtung 50 ist an einem elektrisch isolierenden Teil des Trägers 42 oder einem anderen ortsfesten Teil einer Beschichtungsanlage (nicht dargestellt) befestigt. Die Abschirmwand 51 kann auf den Stäben 21.3 aufsitzen, die einen Rahmen oder ein Gerüst für die Abschirmeinrichtung 50 bilden. Die Abschirmeinrichtung 50 kann zusätzlich einen äußeren Kühlschild (nicht dargestellt) aufweisen, der z. B. einen mit flüssigem Stickstoff oder Wasser gekühlten Doppelmantel umfasst. Da der obere Ringleiter 22.1 einen Abstand von der Seitenwand 12 und der Tiegelöffnung 13 aufweist, ist der Tiegel 10 frei stehend ausschließlich auf der Halteeinrichtung 40 befestigt. Der obere Ringleiter 22.1 besteht zum Beispiel aus einem gebogenen Draht (Torus) aus Tantal mit einem Durchmesser von 2 mm oder einem ringförmigen Tantalblech mit einer Dicke von 1 mm.

Der untere Ringleiter 22.2 ist auf einem ringförmigen Isolator 14 befestigt, der den Tiegel 10 am Tiegelboden 11 umgibt. Der Isolator 14 ist an der Seitenwand 12 oder einem abgewinkelten Teilbereich der Abschirmwand 51 befestigt. Die Befestigung wird zum Beispiel durch Bornitrid gebildet. Der Isolator 14 enthält eine Durchgangsöffnung zur Aufnahme der Anschlussleitung 22.3, die mit dem unteren Ringleiter 22.2 verbunden ist. Der untere Ringleiter 22.2 besteht ebenfalls aus Tantal in Form eines gebogenen Drahtes (Torus) oder ringförmigen Bleches. Die Heizelemente 21.1 sind mittels einer Schweißverbindung am unteren Ringleiter 22.2 befestigt. Der Isolator 14 besteht z. B. aus Bornitrid, Saphir oder Quartz.

Die in Figur 2A in schematischer Schnittansicht gezeigte Ausführungsform der erfindungsgemäßen Verdampferzelle 100 umfasst ebenfalls den Tiegel 10, den Heizwiderstand 21 der Heizeinrichtung 20, die Temperaturmesseinrichtung 30, die Halteeinrichtung 40 und die Abschirmeinrichtung 50. Diese Komponenten sind im Wesentlichen so aufgebaut, wie dies oben unter Bezug auf die Figur 1A beschrieben ist. Ein wesentlicher Unterschied gegenüber der ersten Ausführungsform besteht in Bezug auf die Verbindung der Heizbereiche zu einer Widerstandshülse 21.2.

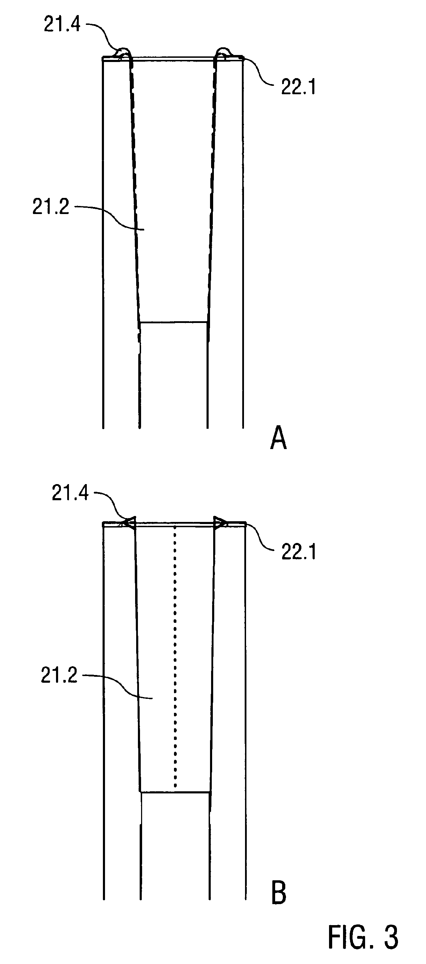

Wie mit der schematischen Seitenansicht in Figur 2B illustriert bilden die Heizbereiche eine konusförmige Widerstandshülse 21.2, deren Durchmesser sich vom Tiegelboden 11 zur Tiegelöffnung 13 vergrößert. Die Widerstandshülse 21.2 ist zum Beispiel aus einer Tantalfolie mit einer Dicke kleiner oder gleich 30 µm, z. B. 25 µm oder 10 µm hergestellt. Der Durchmesser am unteren Rand der Widerstandshülse 21.2 ist beispielsweise im Bereich von 1 cm bis 2 cm gewählt, während der Durchmesser am oberen Rand der Widerstandshülse 21.2 zwischen 2 cm und 3 cm gewählt ist. Die Widerstandshülse 21.2 ist bei der in Figur 2 gezeigten Variante mit ihrem oberen Rand oder mit einem optional am oberen Rand vorgesehenen oberen Ringleiter, wie oben beschrieben, an Stäben befestigt (in Figur 2 nicht dargestellt). Abgewandelte Varianten der Befestigung der Widerstandshülse 21.2 sind unten unter Bezug auf Figur 3 beschrieben. Der untere Rand der Widerstandshülse 21.2 ist mit einem angeschweißten Ring 22.2 versehen und über Haltestifte 15 und einen ringförmigen Isolator 14 an der Halteeinrichtung 40 mit einem axialen Abstand unterhalb des Tiegelbodens 11 befestigt.

Die Haltestifte 15, die die Widerstandshülse 21.2 tragen, sind auf dem ringförmigen Isolator 14 befestigt. Es sind beispielsweise zwei oder mehr Haltestifte 15 vorgesehen, die aus einem elektrisch isolierenden Material, z. B. Bornitrid (insbesondere pyrolytisch abgeschiedenes Bornitrid, PBN, oder aus einem elektrisch leitfähigen Material, z. B. Tantal oder Wolfram bestehen. Einer der Haltestifte 15 kann als elektrische Verbindung der konusförmigen Hülse 21.2 mit der Anschlussleitung 22.3 verwendet werden.

Die in Figur 2A gezeigte Kombination des Isolators 14 mit den Haltestiften 15 kann auch bei der Halterung des Heizwiderstandes bei der Verdampferzelle gemäß Figur 1A vorgesehen sein.

Figur 3 zeigt weitere Varianten der Widerstandshülse 21.2, die vorteilhafterweise eine verbesserte Stabilität der Befestigung des oberen Randes der Widerstandshülse 21.2 ermöglichen. Aus Gründen der Übersichtlichkeit sind in Figur 3 der Tiegel und weitere Teile der Verdampferzelle nicht gezeigt. Die Widerstandshülse 21.2 weist an ihrem oberen Ende in der Umgebung der Tiegelöffnung 13 mehrere Einschnitte auf, durch die in Umfangsrichtung der Widerstandshülse 21.2 biegsame Streifen 21.4 gebildet werden. Die Streifen 21.4 bestehen aus dem Wandmaterial der Widerstandshülse 21.2. Es sind z. B. am oberen Ende der Widerstandshülse 21.2 in Umfangsrichtung 10 bis 20 gleichmäßig verteilte Streifen 21.4 vorgesehen, die in axialer Richtung eine Länge von z. B. 1 cm (Länge der Einschnitte) aufweisen. Die Streifen 21.4 sind in radialer Richtung nach außen geführt, z. B. umgebogen oder geknickt, und am oberen Ringleiter befestigt, z. B. mit dem oberen Ringleiter 22.1 verschweißt.

Vorteilhafterweise verbessert die Befestigung des oberen Randes der Widerstandshülse 21.2 über die Streifen 21.4 den Ausgleich thermischer Änderungen der Länge der Widerstandshülse 21.2. Wenn sich die Länge der Widerstandshülse 21.2 im heißen Zustand z. B. um bis zu zwei Millimeter gegenüber dem kalten Zustand vergrößert, kann diese Längenänderung durch die Streifen 21.4 aufgenommen werden. Somit kann eine unerwünschte thermisch-mechanische Überbeanspruchung der Widerstandshülse 21.2, wie z. B. eine Stauchung oder Verformung, oder sogar deren Abriss vom Ringleiter sicher vermieden werden. Der Ringleiter kann einen im Vergleich zu Figur 2 größeren Durchmesser aufweisen.

Gemäß Figur 3A wird die Widerstandshülse 21.2 an ihrem oberen Ende nicht vollflächig, sondern über die bogenförmigen Streifen 21.4 mit dem oberen Ringleiter verschweißt. Dadurch kann sich die Widerstandshülse 21.2 in axialer Länge ausdehnen, ohne mechanisch überbeansprucht zu werden. Somit kann eine mechanische Zerstörung der Widerstandshülse durch unterschiedliche thermische Ausdehnung im Verhältnis zum kälteren äußeren Teil der Zelle wirksam verhindert werden.

Gemäß Figur 3B werden die Streifen 21.4 nicht bogenförmig geführt, sondern mit engem Radius abgeknickt und nahezu senkrecht zur Tiegelmittelachse radial nach außen geführt. Im kalten Zustand ist der Winkel von Boden her betrachtet größer als 90 Grad, im heißen Zustand kleiner als 90 Grad, vorzugsweise um jeweils denselben Betrag. In Figur 3B sind beide Zustände illustriert. Durch die nahezu senkrechte radiale Abspannung des oberen Hülsenrandes ergibt sich eine stabile seitliche Führung des oberen Endes der Widerstandshülse 21.2, ohne die Möglichkeit der leichten thermischen Ausdehnungsmöglichkeit der Widerstandshülse 21.2 zu verlieren. Vorteilhafterweise wird damit eine seitliche Abweichung der Widerstandshülse 21.2 aus der Symmetrieachse der Zelle und ein Kurzschluss mit dem Tiegel in der Mitte (in Figur 3 nicht dargestellt) sicher vermieden.

Gemäß einer weiteren Ausführungsform der Erfindung kann die Widerstandshülse 21.2 an ihrem unteren Ende, d. h. in der Umgebung des Tiegelbodens Einschnitte aufweisen, durch die in Umfangsrichtung der Widerstandshülse 21.2 biegsame Streifen gebildet werden, wie dies oben unter Bezug auf die Figuren 3A und 3B beschrieben ist. Die Streifen sind dann am unteren Ringleiter 22.2 (siehe Figur 2) befestigt. Des Weiteren kann die Befestigung über gekrümmte oder geknickte Streifen an beiden axialen Enden der Widerstandshülse 21.2 (Heizfolie) vorgesehen sein.

Figur 4 illustriert schematisch die Verbindung der Heizeinrichtung 20 mit der Heizstromquelle 23 und der Hochspannungsquelle 24. Aus Übersichtlichkeitsgründen sind in Figur 3 die oberen und unteren Ringleiter 22.1, 22.2 und die Heizelemente 21.1 neben dem Tiegel 10 gezeigt, obwohl sie in der Praxis den Tiegel 10 umgeben. Gemäß der Erfindung sind die Heizelemente 21.1 durch die Widerstandshülse 21.2 ersetzt.

Die Einstellung des Betriebsstroms der Heizeinrichtung 20 erfolgt mit einer schematisch in Figur 4 gezeigten Regeleinrichtung 60. Die Heizelemente 21.1 auf der Außenseite des Tiegels 10 sind parallel geschaltet an die Heizstromquelle 23 angeschlossen. Die Heizstromquelle 23 ist ein regelbares Gleichstrom-Netzteil für einen Heizstrom bis zu 120 A bei einer Ausgangs-Gleichspannung bis 20 V. Der eine (positive) Anschlusskontakt der Heizstromquelle 23 ist mit dem unteren Ringleiter 22.2 verbunden, während der andere (negative) Anschlusskontakt der Heizstromquelle 23 gemeinsam mit dem oberen Ringleiter 22.1, der Abschirmwand 51, dem negativen Anschlusskontakt der Hochspannungsquelle 24 und einem Anschluss des Thermoelements 31 mit Massepotential verbunden ist. Die Erdung des Thermoelements 31 ist optional vorgesehen. Alternativ können der Messwandler 32 und der Regler 33 auf Tiegelpotential liegen.

Die Hochspannungsquelle 24 ist ein Gleichspannungs-Netzteil mit einem Ausgangsstrom z. B. bis zu 10 A und einer Ausgangsspannung z. B. bis zu 500 V. Aus Kostengründen und wegen des vereinfachten Betriebs im Niederspannungsbereich wird vorzugsweise eine Hochspannungsquelle 24 mit einer Ausgangsspannung von kleiner oder gleich 300 V verwendet. Der positive Anschlusskontakt der Hochspannungsquelle 24 ist über die Halteeinrichtung 40 (siehe Figuren 1 oder 2) mit dem Tiegel 10 verbunden, der beim Elektronenstrahlbetrieb der Heizeinrichtung 20 die Anode repräsentiert, auf die Elektronen von den Heizelementen 21.1 beschleunigt werden. Gemäß abgewandelten Varianten der Erfindung kann die Hochspannungsquelle für niedrigere (zum Beispiel bis zu rd. 50 V) oder höhere Spannungen (zum Beispiel bis zu rd. 5000 V) ausgelegt sein. In der Praxis werden geringere Spannungen bei entsprechend möglichst hohen Strömen bevorzugt, um unbeabsichtigte elektrische Überschläge zu vermeiden und um eine weiche Regelcharakteristik der Elektronenstrahlheizung (Temperatur-Emissionsregelung) zu erhalten.

Der Messwandler 32 des Thermoelements 31 ist mit einem Regler 33 (zum Beispiel einem PID-Regler) verbunden. In Abhängigkeit von der Gestaltung der Regeleinrichtung 60 weist der Regler 33 einen oder zwei Ausgänge auf, von denen Stellsignale an die Heizstromquelle 23 und optional an die Hochspannungsquelle 24 geliefert werden.

Vorzugsweise umfasst die Regeleinrichtung 60 einen einzigen Regelkreis 61. Im Regelkreis 61 wird die Ausgangsspannung der Heizstromquelle 23, mit der die oberen und unteren Ringleiter 22.1, 22.2 beaufschlagt werden, in Abhängigkeit von der Betriebstemperatur des Tiegels 10 geregelt. Alternativ können wie bei der herkömmlichen Verdampferzelle zwei Regelkreise 61, 62 vorgesehen sein (siehe gestrichelter Pfeil von 33 nach 24). Im optional vorgesehenen Regelkreis 62 wird der Elektronenstrom von den Heizelementen 21.1 zum Tiegel 10 ebenfalls in Abhängigkeit von der Betriebstemperatur des Tiegels 10 geregelt.

Bei der Temperatureinstellung wird bspw. die in Figur 5 gezeigte Kennlinie realisiert. In einer ersten Betriebsphase erfolgt zunächst eine Beaufschlagung der Heizelemente 21.1 mit einer Heizspannung, so dass durch die Heizelemente 21.1 ein Heizstrom fließt. Die Heizleistung Pₜₕ und damit die Temperatur des Tiegels 10 wird ausschließlich über die Heizspannung geregelt. Mit der Regeleinrichtung 33 wird gemäß Figur 5 die Temperatur im Tiegel zunächst mit der thermischen Heizung (gepunktet, Leistung Pₜₕ) erhöht, bis eine Temperatur erreicht ist, bei der die Elektronenemission vom Heizwiderstand 21 einsetzt. Wenn durch die Widerstandsheizung eine ausreichend hohe Temperatur von z. B. 1000°C bis 1500°C erreicht wurde, setzt in einer weiteren Betriebsphase die Elektronenstrahlheizung ein. Die Elektronenemission von den Heizelementen 21.1 zum Tiegel 10 setzt bspw. bereits bei einer Hochspannung von 300 V ein. Die Heizung wird durch die Elektronenstrahl-Heizung (gestrichelt, Leistung Pₑ) überlagert. Beide Anteile addieren sich zur Leistung P_{ges} (durchgezogen gezeichnet). Zur weiteren Temperaturerhöhung wird die Leistung Pₜₕ der Widerstandsheizung nicht erhöht, sondern die Elektronenstrahlheizung verwendet. Die Widerstandsheizung wird vermindert. Erfindungsgemäß kann die Widerstandsheizung bei einer Tiegeltemperatur oberhalb von 2200 °C sogar abgeschaltet werden, da die Heizelemente durch den Tiegel geheizt werden. Mit einer Steigerung des Elektronenstroms auf z. B. 1 A bei einer Spannung von 2000 V über die Vakuumstrecke zwischen den Heizelementen und dem Tiegel wird eine Temperatur von 2700°C erreicht.

Um einen möglichst fließenden Übergang der Temperatureinstellung beim Wechsel von der Widerstands- zur Elektronenstrahlheizung zu erreichen, wird die Hochspannung der Hochspannungsquelle 24 bereits während der ersten Betriebsphase der Widerstandsheizung an den Tiegel 10 angelegt.

Einzelheiten einer weiteren Ausführungsform der Verdampferzelle 100 sind in den Figuren 6A (perspektivische Schnittansicht), 6B (vergrößerte Teilansicht) und 6C (Seitenansicht) dargestellt. Der wesentliche Unterschied zwischen den Ausführungsformen der Figur 1 (oder 2) und 6 besteht in der geometrischen Form des Tiegels 10. Im Übrigen können die in Figur 6 gezeigten Einzelheiten auch bei den in den Figuren 1, 2 oder 3 gezeigten Ausführungsformen der Erfindung realisiert sein.

Die Figuren 6A und 6B zeigen Einzelheiten des Tiegels 10, des Heizwiderstandes 21, der Temperaturmesseinrichtung 30, der Halteeinrichtung 40 und der Abschirmeinrichtung 50. Der Tiegel 10 ist ein gerader Hohlzylinder aus Wolframblech. Die Abschirmwand 51 besteht aus mehreren Lagen einer Tantalfolie. Die Heizelemente 21.1 des Heizwiderstandes 21 erstrecken sich über die gesamte Länge des Tiegels 10. Vorteilhafterweise erfolgt bei der Elektronenstrahlheizung die Elektronenemission ebenfalls entlang der gesamten Länge der Heizelemente 21.1.

In den Figuren 6A und 6B ist beispielhaft eine Konusform des Heizwiderstandes 21 gezeigt, deren Durchmesser sich in Axialrichtung zur Tiegelöffnung vergrößert.

Die mechanische Halterung der Heizelemente 21.1 und des oberen Ringleiters 22.1 erfolgt mit den Stäben 21.3, die auf der Innenseite der Abschirmwand 51 angeordnet sind.

Der Hohlzylinder 41 der Halteeinrichtung 40 verjüngt sich an seinem unteren Ende konusförmig. Die konusförmige Verjüngung steckt in einer ebenfalls konusförmigen Aufnahme 43 des Trägers 42. Die Fixierung des Hohlzylinders 41 in der Halterung 43 erfolgt mit einem ebenfalls konusförmigen Innenstück 44, das mit einer Spannschraube 45 in die Aufnahme 43 des Trägers 42 gezogen werden kann. Die Spannschraube 45 ist innen hohl, so dass der Kanal 47 gebildet wird, um das Thermoelement 31 axial in den Innenraum des Hohlzylinders 41 durchzuführen. Auf der Oberseite des Trägers 42 sind mehrere Lagen eines Tantalbleches 46 angeordnet, um die thermische Isolation zwischen dem Tiegel 10 und dem Träger 42 zu verbessern.

Der Träger 42 ist mit einem Sockel 70 über starre Rohrleitungen 71 verbunden, in denen die Anschlussleitungen des Heizwiderstandes, die Hochspannungsleitung des Tiegels und die Leitungen des Thermoelements angeordnet sind. Die Rohrleitungen 71 dienen des Weiteren einer Kühlung der Anschlussleitungen und der Halteeinrichtung 40 mit Kühlwasser, das über Kühlwasseranschlüsse 72 (siehe Figur 6C) zugeführt wird. Der Sockel 70 weist einen Vakuumflansch (z. B. mit der Größe CF 40) auf, der an einer Beschichtungsanlage montierbar ist.

Die in der vorstehenden Beschreibung, den Zeichnungen und den Ansprüchen offenbarten Merkmale der Erfindung können sowohl einzeln als auch in Kombination für die Verwirklichung der Erfindung in ihren verschiedenen Ausgestaltungen von Bedeutung sein.

## Patentansprüche

1. Verdampferzelle (100), die zur Verdampfung von Verdampfungsgut eingerichtet ist, umfassend:
- einen Tiegel (10) zur Aufnahme des Verdampfungsguts, der einen Tiegelboden (11), eine Seitenwand (12), die sich in einer Axialrichtung des Tiegels (10) erstreckt, und eine Tiegelöffnung (13), die in der Axialrichtung des Tiegels (10) gegenüber zum Tiegelboden (11) zum Austritt des Verdampfungsguts angeordnet ist, aufweist, und
- eine Heizeinrichtung (20) mit einem Heizwiderstand (21), der eine Vielzahl von Heizbereichen (21.1, 21.2) umfasst, die auf einer Außenseite des Tiegels (10) angeordnet sind und sich entlang der Axialrichtung des Tiegels (10) erstrecken, wobei
- die Heizbereiche (21.1, 21.2) zur mehrseitigen Widerstandsheizung des Tiegels (10) eingerichtet sind,
- die Heizbereiche (21.1, 21.2) so gebildet sind, dass ein Heizstrom durch den Heizwiderstand (21) durch alle Heizbereiche (21.1, 21.2) parallel und gleichsinnig fließt, und
- die Heizbereiche (21.1, 21.2) zu einem flächigen Widerstandsmaterial verbunden sind, das eine Widerstandshülse (21.2) bildet, die den Tiegel (10) radial allseitig umgibt,
**dadurch gekennzeichnet, dass**
- die Heizbereiche (21.1, 21.2) eine Metallfolie umfassen, welche die Widerstandshülse bildet und eine in der Axialrichtung des Tiegels (10) konstante Dicke aufweist,
- die Widerstandshülse (21.2) konusförmig mit einer sich von der Tiegelöffnung (13) zum Tiegelboden (11) verringernden Querschnittsdimension ist, und
- die Metallfolie auf der Außenseite der Seitenwand (12) mit einem radialen Abstand von deren Oberfläche angeordnet ist.

2. Verdampferzelle nach Anspruch 1, bei der
- der Tiegel (10) und der Heizwiderstand (21) aus Tantal bestehen.

3. Verdampferzelle nach Anspruch 1 oder 2, bei der
- die Widerstandshülse (21.2) an einem oberen Rand, der den Tiegel (10) bei der Tiegelöffnung (13) umgibt, und/oder an einem unteren Rand, der den Tiegel (10) bei dem Tiegelboden (11) umgibt, in radialer Richtung nach außen gekrümmte Streifen (21.4) aufweist, die zur Befestigung der Widerstandshülse (21.2) vorgesehen sind,und/oder
- der Heizwiderstand (21) über einen elektrischen Isolator (14) mit dem Tiegel (10) oder einer Halteeinrichtung (40) des Tiegels (10) oder dem Tiegelboden (11) verbunden ist.

4. Verdampferzelle nach Anspruch 3, bei der
- die Widerstandshülse (21.2) an einem unteren Rand mit einem unteren Ringleiter (22.2) versehen ist, der mit dem elektrischen Isolator (14) verbunden ist.

5. Verdampferzelle nach mindestens einem der vorhergehenden Ansprüche, bei der
- eine Abschirmeinrichtung (50) vorgesehen ist, die eine Abschirmwand (51) aufweist, die den Tiegel (10) radial umgibt, wobei der Heizwiderstand (21) bei der Tiegelöffnung (13) elektrisch mit der Abschirmwand (51) verbunden ist, und/oder
- der Heizwiderstand (21) bei der Tiegelöffnung (13) einen größeren oder einen geringeren radialen Abstand von der Seitenwand (12) aufweist als bei dem Tiegelboden (11).

6. Verdampferzelle nach Anspruch 5, bei der
- der Heizwiderstand (21) an der Abschirmwand (51) befestigt ist, und/oder
- die Abschirmwand (51) aus Tantal besteht.

7. Verdampferzelle nach mindestens einem der vorhergehenden Ansprüche, bei der
- eine Temperaturmesseinrichtung (30) vorgesehen ist, mit der eine Betriebstemperatur der Verdampferzelle messbar ist und die mindestens eines von einem Thermoelement (31), einem Bolometerelement und einem Pyrometerelement umfasst, und/oder
- eine Regeleinrichtung (60) zur Einstellung der Heizeinrichtung (20) vorgesehen ist.

8. Verdampferzelle nach Anspruch 7, bei der
- das Thermoelement (31) ein gerades Bauteil umfasst, das sich entlang der Axialrichtung des Tiegels (10) erstreckt und auf einer Unterseite des Tiegelbodens (11) entlang der Axialrichtung des Tiegels (10) verschiebbar angeordnet ist.

9. Verwendung einer Verdampferzelle nach mindestens einem der Ansprüche 1 bis 8 als Dampfquelle in einer Beschichtungsanlage.

## Claims

1. Evaporator cell (100), which is adapted for an evaporation of an evaporant, comprising:
- a crucible (10) for accomodating the evaporant, which has a crucible bottom (11), a side wall (12), which extends in an axial direction of the crucible (10), and a crucible opening (13), which is arranged along the axial direction of the crucible (10) opposite to the crucible bottom (11) for an outlet of the evaporant, and
- a heating device (20) with a heating resistor (21), which comprises a plurality of heating zones (21.1, 21.2), which are arranged on an outer side of the crucible (10) and extend along the axial direction of the crucible (10), wherein
- the heating zones (21.1, 21.2) are adapted for multilateral resistance heating of the crucible (10),
- the heating zones (21.1, 21.2) are formed in such a way that a heating current through the heating resistor (21) flows in parallel and in the same sense through the heating resistor (21) through all heating zones (21.1, 21.2), and
- the heating zones (21.1, 21.2) are connected as a laminar resistance material, which forms a resistance sleeve (21.2), which surrounds the crucible (10) in the radial direction on all sides,
**characterized in that**
- the heating zones (21.1, 21.2) comprise a metal foil, which forms the resistance sleeve and as a constant thickness along the axial direction of the crucible (10),
- the resistance sleeve (21.2) has a conical shape with a cross-sectional dimension reducing from the crucible opening (13) to the crucible bottom (11), and
- the metal foil is arranged on the outer side of the sidewall (12) with a radial distance from the surface thereof.

2. Evaporator cell according to claim 1, wherein
- the crucible (10) and the heating resistor (21) consist of tantalum.

3. Evaporator cell according to claim 1 or 2, wherein
- the resistance sleeve (21.2) has, on a top edge, which surrounds the crucible (10) at the crucible opening (13), and/or on a bottom edge, which surrounds the crucible (10) at the crucible bottom (11), strips (21.4) curved outwards in the radial direction, which are provided for securing the resistance sleeve (21.2), and/or
- the heating resistor (21) is connected via an electrical insulator (14) to the crucible (10) or a holding device (40) of the crucible (10) or the crucible bottom (11).

4. Evaporator cell according to claim 3, wherein
- the resistance sleeve (21.2) is provided, at a bottom edge, with a lower ringshaped conductor (22.2), which is connected with the electrical insulator (14).

5. Evaporator cell according to at least one of the preceding claims, wherein
- a shielding device (50) is provided, which has a shielding wall (51), which surrounds the crucible (10) radially, wherein the heating resistor (21) is connected electrically to the shielding wall (51) at the crucible opening (13), and/or
- the heating resistor (21) has a larger or a smaller radial distance from the side wall (12) at the crucible opening (13) than at the crucible bottom (11).

6. Evaporator cell according to claim 5, wherein
- the heating resistor (21) is fixed to the shielding wall (51), and/or
- the shielding wall (51) consists of tantalum.

7. Evaporator cell according to at least one of the preceding claims, wherein
- a temperature measuring device (30) is provided, with which an operating temperature of the evaporator cell can be measured and which comprises at least one of a thermocouple (31), a bolometer element and a pyrometer element, and/or
- a control device (60) is provided for adjusting the heating device (20).

8. Evaporator cell according to claim 7, wherein
- the thermocouple (31) comprises a straight component, which extends axially along the crucible (10) and is arranged on an underside of the crucible bottom (11) movable axially along the crucible (10).

9. Use of an evaporator cell according to at least one of claims 1 to 8 as the source of vapor in a coating installation.

## Revendications

1. Cellule d'évaporation (100), qui est mise au point aux fins de l'évaporation d'un produit à évaporer, comprenant :
- un creuset (10) servant à recevoir le produit à évaporer, qui présente un fond de creuset (11), une paroi latérale (12), qui s'étend dans un sens axial du creuset (10), et une ouverture de creuset (13), qui est disposée dans le sens axial du creuset (10) par rapport au fond de creuset (11) aux fins de la sortie du produit à évaporer, et
- un dispositif de chauffage (20) comprenant une résistance de chauffage (21), qui comprend une pluralité de zones de chauffage (21.1, 21.2), qui sont disposées sur un côté extérieur du creuset (10) et qui s'étendent le long du sens axial du creuset (10), sachant
- que les zones de chauffage (21.1, 21.2) sont mises au point aux fins du chauffage par résistance sur plusieurs côtés du creuset (10),
- que les zones de chauffage (21.1, 21.2) sont formées de sorte qu'un courant de chauffage passant par la résistance de chauffage (21) s'écoule de manière parallèle et dans le même sens à travers toutes les zones de chauffage (21.1, 21.2), et
- que les zones de chauffage (21.1, 21.2) sont reliées pour former un matériau de résistance plat, qui forme une gaine résistante (21.2), qui entoure radialement de tous les côtés le creuset (10),
**caractérisée en ce**
- **que** les zones de chauffage (21.1, 21.2) comprennent un film métallique, qui forme la gaine résistante et qui présente une épaisseur constante dans le sens axial du creuset (10),
- **que** la gaine résistante (21.2) est de forme conique dont la section transversale présente une dimension se réduisant depuis l'ouverture de creuset (13) en direction du fond de creuset (11), et
- **que** le film métallique est disposé sur le côté extérieur de la paroi latérale (12) à une distance radiale de la surface de cette dernière.

2. Cellule d'évaporation selon la revendication 1, dans le cadre de laquelle
- le creuset (10) et la résistance de chauffage (21) sont constitués de tantale.

3. Cellule d'évaporation selon la revendication 1 ou 2, dans le cadre de laquelle
- la gaine résistante (21.2) présente, au niveau d'un bord supérieur qui entoure le creuset (10) à proximité de l'ouverture de creuset (13), et/ou au niveau d'un bord inférieur qui entoure le creuset (10) à proximité du fond de creuset (11), des bandes (21.4) incurvées dans le sens radial vers l'extérieur, lesquelles sont prévues aux fins de la fixation de la gaine résistante (21.2), et/ou
- la résistance de chauffage (21) est reliée, par l'intermédiaire d'un isolant (14) électrique, au creuset (10) ou à un dispositif de maintien (40) du creuset (10) ou au fond de creuset (11).

4. Cellule d'évaporation selon la revendication 3, dans le cadre de laquelle
- la gaine résistante (21.2) est pourvue, au niveau d'un bord inférieur, d'un conducteur annulaire (22.2) inférieur, qui est relié à l'isolant (14) électrique.

5. Cellule d'évaporation selon au moins l'une quelconque des revendications précédentes, dans le cadre de laquelle
- un dispositif de blindage (50) est prévu, qui présente une paroi de blindage (51), qui entoure de manière radiale le creuset (10), sachant que la résistance de chauffage (21) à proximité de l'ouverture de creuset (13) est reliée de manière électrique à la paroi de blindage (51), et/ou
- la résistance de chauffage (21) à proximité de l'ouverture de creuset (13) présente une distance radiale de la paroi latérale (12) plus grande ou plus petite qu'à proximité du fond de creuset (11).

6. Cellule d'évaporation selon la revendication 5, dans le cadre de laquelle
- la résistance de chauffage (21) est fixée au niveau de la paroi de blindage (51), et/ou
- la paroi de blindage (51) est constituée de tantale.

7. Cellule d'évaporation selon au moins l'une quelconque des revendications précédentes, dans le cadre de laquelle
- un dispositif de mesure de température (30) est prévu, lequel permet de mesurer une température de fonctionnement de la cellule d'évaporation et qui comprend au moins l'un des éléments suivants, un thermocouple (31), un élément formant un bolomètre et un élément formant un pyromètre, et/ou
- un dispositif de régulation (60) est prévu aux fins du réglage du dispositif de chauffage (20).

8. Cellule d'évaporation selon la revendication 7, dans le cadre de laquelle
- le thermocouple (31) comprend un composant rectiligne, qui s'étend le long du sens axial du creuset (10) et qui est disposé sur un côté inférieur du fond de creuset (11) de manière à pouvoir être déplacé par coulissement le long du sens axial du creuset (10).

9. Utilisation d'une cellule d'évaporation selon au moins l'une quelconque des revendications 1 à 8 en tant que source de vapeur dans une installation de revêtement.
